(19)

Europäisches
Patentamt
European
Patent Office
Office européen
des brevets

(11)  **EP 2 405 541 A1**

(12)  **EUROPEAN PATENT APPLICATION**
published in accordance with Art. 153(4) EPC

(43) Date of publication:
**11.01.2012   Bulletin 2012/02**

(51) Int Cl.:
***H01S 5/062*** (2006.01)

(21) Application number: **10748497.4**

(22) Date of filing: **02.03.2010**

(86) International application number:
**PCT/JP2010/001411**

(87) International publication number:
**WO 2010/100898 (10.09.2010 Gazette 2010/36)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority:  **04.03.2009   JP 2009050244**

(71) Applicant: **Mitsubishi Electric Corporation Tokyo 100-8310 (JP)**

(72) Inventors:
 • **INOUE, Yoko**
  **Tokyo 100-8310 (JP)**

 • **YANAGISAWA, Takayuki**
  **Tokyo 100-8310 (JP)**
 • **MIYATA, Akihisa**
  **Tokyo 100-8310 (JP)**

(74) Representative: **HOFFMANN EITLE**
  **Patent- und Rechtsanwälte**
  **Arabellastraße 4**
  **81925 München (DE)**

(54)   **LASER LIGHT SOURCE APPARATUS AND IMAGE DISPLAY APPARATUS**

(57)    A laser light source device has a laser light source (21) for emitting a laser beam (L), a laser driver (31) for driving the laser light source, a light-collecting lens (24) for collecting the laser beam and reflecting a part of the laser beam, an optical sensor (29) for receiving a reflected laser beam (LS) which has been reflected by the light-collecting lens and outputting a detection signal corresponding to intensity of the reflected laser beam, and a controller (30) for controlling driving of the laser light source by the laser driver (31) in accordance with the detection signal, and the light-collecting lens (24) is disposed in a eccentric-rotated state so that an optical axis of the light-collecting lens (A24) has a tilt (angle $\alpha$) with respect to a central ray (L0) of the laser beam (L) being incident on the light-collecting lens.

FIG. 1

EP 2 405 541 A1

**Description**

**TECHNICAL FIELD**

The present invention relates to a laser light source device for emitting a laser beam and an image display apparatus using the laser light source device.

**BACKGROUND ART**

Recently, a lot of image display apparatuses (laser displays) for displaying images by spatial modulated laser beams onto screens are proposed. The apparatuses have an advantage to enable displaying a high-quality image which has high directivity, high monochromaticity, high brightness, and wide color reproducibility. On the other hand, when color reproduction is performed by mixing primary-color laser beams, a variation in a beam power or an oscillation wavelength of each of the primary color laser beams remarkably appears as a variation in a color tone of a display image. Because the human eye is sensitive especially to a variation in a color tone, it is required to control strictly a variation in a beam power of a laser beam and to maintain a stable color tone, in a laser light source device for an image display apparatus.

In usual, in order to control a beam power of a laser beam, a beam splitter is disposed in an optical path, a split laser beam is received by an optical sensor, thereby a relative variation in the beam power of the laser beam is measured. Furthermore, there is a proposi-tion that an optical sensor receives a reflected beam from an optical component, particularly, an emission objective lens, in an emission head of a laser light source device (see Patent Document 1, for example). Moreover, there is another proposition to extract a part of a laser beam by providing a transmissive part on a reflective surface of an intermediate mirror (see Patent Document 2, for example).

Patent Document 1 is Japanese Patent Kokai Publication No. 5-133798, and Patent Document 2 is Japanese Patent Kokai Publication No. 2003-270579.

**DISCLOSURE OF THE INVENTION**

**PROBLEMS TO BE SOLVED BY THE INVENTION**

However, if the beam splitter is disposed, there is a problem that the laser light source device increases in size and costs of manufacture because components of the laser light source device increase.

Moreover, in the case of Patent Document 1, in order to improve a light-receiving sensitivity of a sample beam (which returns such that its optical axis agrees with that of its main beam) which is a reflected beam from the optical component of the emission head, it is required that an optical sensor be disposed near the optical axis, however, it cannot be disposed sufficiently closely because of an interference with the main beam. For this reason, there are problems that only a part of ambient light out of the reflected beam from the optical component is incident on the optical sensor and the light-receiving sensitivity is unstable; and that a proportional relationship between a detection signal and a beam power of the main laser beam cannot be obtained.

Furthermore, if the conventional laser light source device is used as a light source for a projection-type image display apparatus, there is a problem that brightness and a color tone of a display image are unstable.

In the case of Patent Document 2, there is a problem that the transmissive surface of the intermediate mirror should have a lens shape in order to receive the extracted laser beam by a sensor. There is a further problem that a power of the laser beam received by the sensor is influenced by a coating characteristic of the intermediate mirror, and easily influenced by an environmental change and a change over time.

Thus, the present invention is made to solve the problems of the conventional arts, and an object of the present invention is to provide a laser light source device capable of stably maintaining a beam power of a laser beam without increasing components or adding shape or structure to components, and an image display apparatus using the laser light source device and obtaining stable brightness and color tone.

**MEANS OF SOLVING THE PROBLEMS**

A laser light source device concerning an aspect of the present invention includes: a laser light source for emitting a laser beam; a laser driving means for driving the laser light source; a light collector for collecting the laser beam and including an optical element which reflects a part of the laser beam; an optical sensor for receiving a reflected laser beam which has been reflected by the optical element and outputting a detection signal corresponding to intensity of the reflected laser beam; and a controlling means for controlling driving of the laser light source by the laser driving means in accordance with the detection signal; wherein the optical element is disposed in an eccentric-rotated state so that an optical axis of the optical element has a tilt with respect to a central ray of the laser beam being incident on the optical element.

The laser light source device concerning an aspect of the present invention includes the laser light source device, and a means for spatial modulating a laser beam exiting from the laser light source device and projecting it onto a screen.

## EFFECTS OF THE INVENTION

The laser light source device according to an aspect of the present invention has an advantageous effect that a beam power of a laser beam can be kept stable without increasing components.

Furthermore, the image display apparatus according to an aspect of the present invention, in which the beam power of the laser beam can be kept stable without increasing components, has an advantageous effect that brightness and a color tone of a display image can be kept stable.

## BRIER DESCRIPTION OF THE DRAWINGS

FIG. 1 is a diagram schematically illustrating an example of a structure of a laser light source device according to a first embodiment of the present invention.

FIG. 2 is a graph indicating a relationship between an incidence angle and Fresnel reflectance.

FIG. 3 is a diagram for explaining an optical axis deviation.

FIGs. 4A and 4B are diagrams illustrating a difference in spots due to whether astigmatism occurs or not.

FIG. 5 is a diagram schematically illustrating an example of a structure of a laser light source device according to a second embodiment of the present invention.

FIG. 6 is a diagram illustrating an example of a structure when the laser light source device according to the second embodiment of the present invention has a diffusion plate.

FIG. 7 is a diagram schematically illustrating an example of a structure of a laser light source device according to a third embodiment of the present invention.

FIGs. 8A to 8E are diagrams for explaining drive timings of a field sequential spatial modulating element and lasers, when the laser light source device according to the first embodiment is applied to an image display apparatus.

FIGs. 9A and 9B are diagrams illustrating eccentric-rotated states of light-collecting lenses.

FIG. 10 is a graph indicating a luminosity curve.

FIG. 11 is a graph indicating an example of a wavelength sensitivity of an optical sensor.

## BEST MODE FOR CARRYING OUT THE INVENTION

First Embodiment

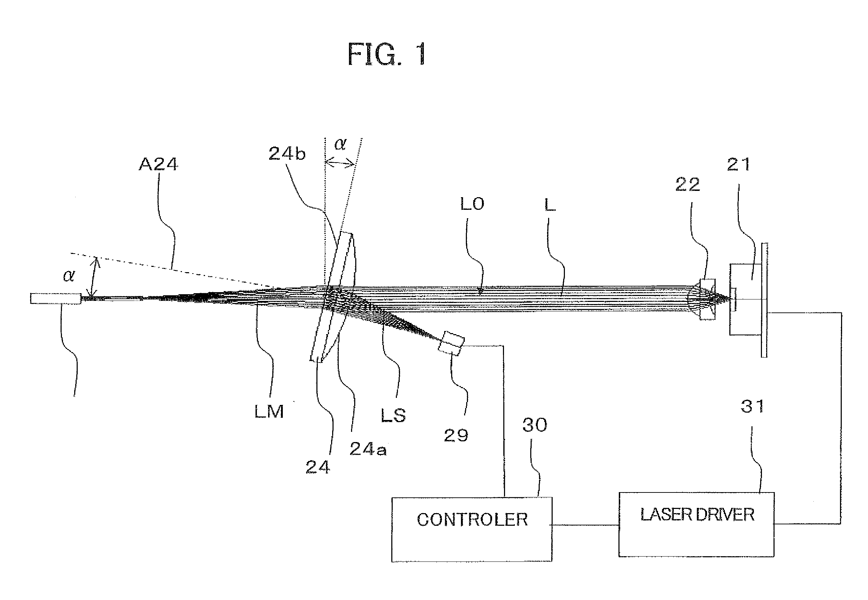

FIG. 1 is a diagram schematically illustrating an example of a structure of a laser light source device according to a first embodiment of the present invention. As shown in FIG. 1, the laser light source device according to the first embodiment has a laser light source 21; a laser driver (laser driving means) 31 for driving the laser light source 21; a shaping optical element 22 being formed by a lens for approximately parallelizing laser beam L of colors being emitted from the color laser light source 21 and the like; and a light-collecting lens 24 being an optical element for collecting the laser beam L and having a spherical surface. The laser light source device according to the first embodiment has an optical sensor 29 for outputting a detection signal corresponding to a beam power of a reflected laser beam in a position where the reflected laser beam (sample beam) from the light-collecting lens 24 is collected; and a controller 30 for controlling driving of the laser light source 21 by the laser driver 31 in accordance with the detection signal from the optical sensor 29. At a position where transmission beams from the light-collecting lens 24 are collected, the laser light source device has an optical fiber 140 for combining and transmitting the laser beams.

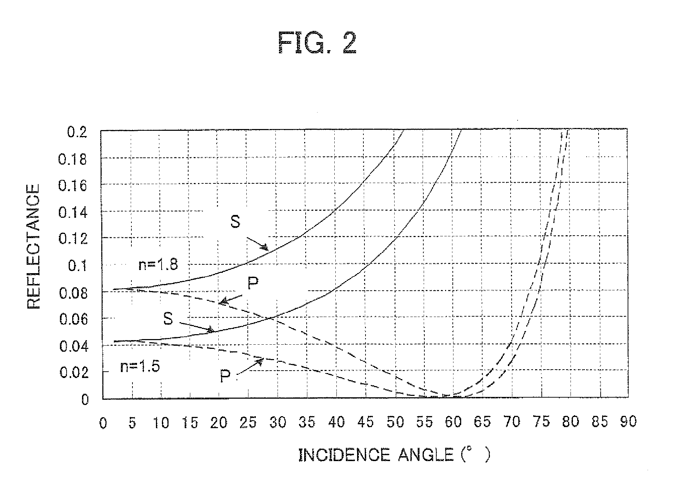

In the first embodiment, the laser beam which is emitted from the laser light source 21 is approximately parallelized by the shaping optical element 22 and is incident on the light-collecting lens 24. The light-collecting lens 24, on which the laser beam L is incident, is disposed in an eccentric-rotated state so that an optical axis A24 of the light-collecting lens 24 has a tilt (angle $\alpha$) with respect to a central ray (also referred to as an 'optical axis') L0 of the laser beam L which is incident on the light-collecting lens 24. A rotation axis of the eccentric-rotation has a rotation axis (a rotation axis extending in a direction perpendicular to a sheet on which FIG. 1 is illustrated) on a surface at a right angle to the central ray L0 of the laser beam L which is incident on the light-collecting lens 24. The light-collecting lens 24 has a low reflection coating on its lens surface, except on an exit surface 24b of the light-collecting lens 24, to reduce loss due to Fresnel reflection. At the exit surface 24b of the light-collecting lens 24, Fresnel reflection, reflectance of which is determined by a refractive index between lens material and the air, occurs. In the first embodiment, a material of the light-collecting lens 24 has a refractive index of approximately 1.5, and a laser beam of an approximately visible wavelength band produces approximately 4% of reflected beam when an incidence angle is 10 degrees, as shown in FIG. 2. Because the light-collecting lens 24 is eccentric-rotated at the angle α, a reflected beam at the exit surface 24b of the light-collecting lens 4 has an optical path which returns inside the light-collecting lens 24 and then exits from an incidence surface 24a to the air, and the beam is a reflected laser beam (sample beam) LS which is detected by the optical sensor 29, apart from a main laser beam LM. By passing through the incidence surface 24a of the light-collecting lens 24 twice, the reflected laser beam LS is collected under an influence of a lens function while travelling. Then, almost all amounts of the beam are incident on the optical sensor 29 which is disposed at a collection point. Because a beam power of the reflected laser beam LS which is detected by the optical sensor 29 has a certain relationship (an approximately proportional relationship, for example) to a beam power of the main laser beam LM, it is equal to that the optical sensor 29 detects the beam power of the main laser beam LM which exits from the laser light source device.

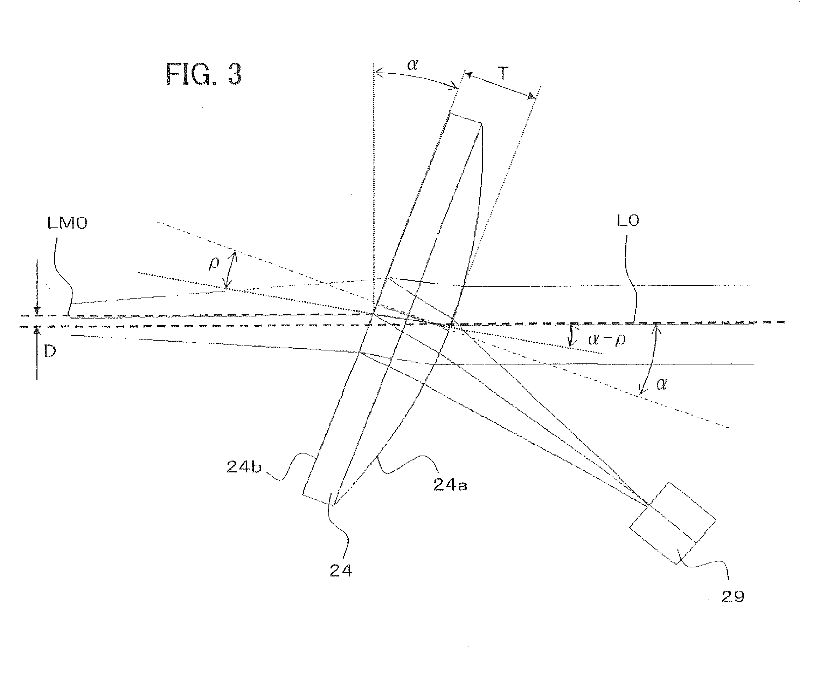

On the other hand, the laser beam L which passes through the light-collecting lens 24 is collected by the lens function of the light-collecting lens 24, and the light-collecting lens 24 is disposed so as to have a tilt (angle α) with respect to the central ray L0 of the laser beam L (this is also referred to as 'eccentric-rotation'). For this reason, an optical axis deviation and astigmatism arise. An explanatory diagram of the optical axis deviation is illustrated in FIG. 3. If an incident beam on a tilt surface having an optical axis and an angle, the beam is refracted according to Snell's law and the optical axis deviation arises. A central ray LM0 of the main laser beam LM which passes through the light-collecting lens 24 shifts a shift amount D in parallel to the central ray L0, before an incidence on the light-collecting lens 24, in a rotation surface of the light-collecting lens 24 (a surface in parallel to a sheet on which FIG. 3 is illustrated). The shift amount of the central ray L0, i.e., the deviation amount D, can be determined from the following Equations 1 and 2, where a center thickness of the light-collecting lens 24 is T, a refractive index of the light-collecting lens 24 is N24, a refractive index of an outside area of the light-collecting lens 24 is N0, and an angle of refraction is ρ:

$$\sin \rho = \sin \alpha \times \frac{N0}{N24} \qquad (1)$$

$$D = \frac{T}{\cos \rho} \times \sin\left(\alpha - \rho\right) \qquad (2)$$

Thus, in an optical system which follows the light-collecting lens 24 (i.e., which is disposed on a downstream side in a light propagating direction, in comparison with the light-collecting lens 24), its optical axis shifts the deviation amount D in parallel to the central ray L0, thereby the optical axis deviation due to the eccentric-rotation of the light-collecting lens 24 can be solved. If the deviation amount D of the optical axis is sufficiently small against a diameter of a core of the optical fiber on which a light beam from the optical system shown in FIG. 3 is incident (i.e., combined) and a desirable characteristic can be obtained without correction, the optical axis deviation in the optical system which follows the light-collecting lens 24 may not be corrected.

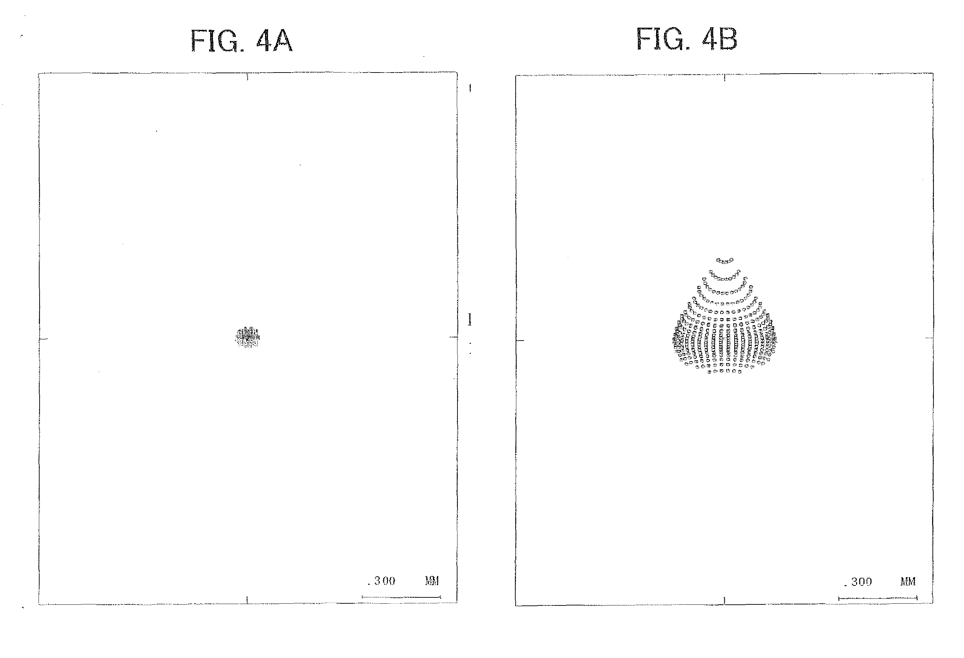

Furthermore, a focused spot changes due to astigmatism. PIG. 4A illustrates a spot diagram which is formed when the light-collecting lens 24 is not eccentric-rotated and an ideal parallel ray is incident on the light-collecting lens 24; and FIG. 4B illustrates a spot diagram which is formed when the light-collecting lens 24 is eccentric-rotated as in FIG. 3 and the ideal parallel ray is incident on the light-collecting lens 24. If the light-collecting lens 24 is not eccentric-rotated as shown in FIG. 4A, the spot is small; whereas if the light-collecting lens 24 is eccentric-rotated as shown in FIG. 4B, the spot is large.

On the other hand, the optical fiber 140 is a large-diameter multi mode fiber having a core diameter of several hundred μm to several mm. Here, a background that the large-diameter multi mode fiber can be used as the optical fiber 140 will be briefly explained. After the beam is transmitted by the optical fiber 140, when the laser beam which exits from an optical-fiber exit surface is used as a light source of an image display apparatus, it is required to connect the laser beam which exits from the optical fiber 140 with an aperture of an engine of the image display apparatus with less loss. As a manner of the connection, the exit laser light from the optical fiber is directly connected with the aperture of the engine, connected with through the use of a relay optical system, or the like. In any case, the core diameter of the large-diameter multi mode fiber is restricted in accordance with etendue of an aperture of the engine, i.e., etendue of a spatial modulating element. For example, etendue of a two-dimensional (2D) spatial modulating element is 5 to 10 mm$^2 \cdot$

sr. Etendue of a large-diameter multi mode fiber is 0.1 mm$^2$·sr, if a core diameter $\varphi$ is 1.0 mm and a numerical aperture NA is 0.2. This value is smaller several to several ten times with respect to the aperture of the engine and it is found that the laser beam transmitted by the large-diameter multi mode fiber can be connected with the image display apparatus without light loss.

Furthermore, etendue of a laser light source is 10$^{-6}$ to 10$^{-7}$ mm$^2$·sr in the case of an ideal laser beam. Moreover, in a present state, there are cases that such as a multi-emitter LD (laser diode) and an SSL (solid state laser) of low-cost, high-power, and broad-area type are used. In such cases, etendue of the light source is approximately 10$^{-4}$ to 10$^{-2}$ mm$^2$·sr. Thus, the etendue of the laser light source is small with respect to the etendue of the multi mode fiber, the connection can be realized without light loss or a multi mode fiber diameter by which the connection is realized without light loss can be selected, even if the light-collecting lens 24 is eccentric-rotated and astigmatism arises.

In the case that polarization of the laser light source 21 is linear polarization, as indicated by the graph of FIG. 2 illustrating a relationship between an incidence angle and Fresnel reflectance, if a polarization direction of the laser beam L from the laser light source 21 is made to be parallel to the reflective surface 24b of the light-collecting lens 24, loss in the main laser beam LM due to Fresnel reflection can be reduced. In FIG. 2, 'S' denotes S-polarization and 'P' denotes P-polarization.

When the exit surface 24b of the light-collecting lens 24 is not coated and the reflected laser beam LS is extracted by Fresnel reflection, a stable sensing of an optical output (detecting the reflected laser beam by the optical sensor 29) can be realized without influence of temperature/humidity characteristics due to a change over time or an environmental change in a coating reflectance. However, if a high-precision sensing is unnecessary and it is desired to reduce loss in a beam power of the main laser beam LM, a low reflection coating may be applied on the exit surface 24b of the light-collecting lens 24.

Second Embodiment

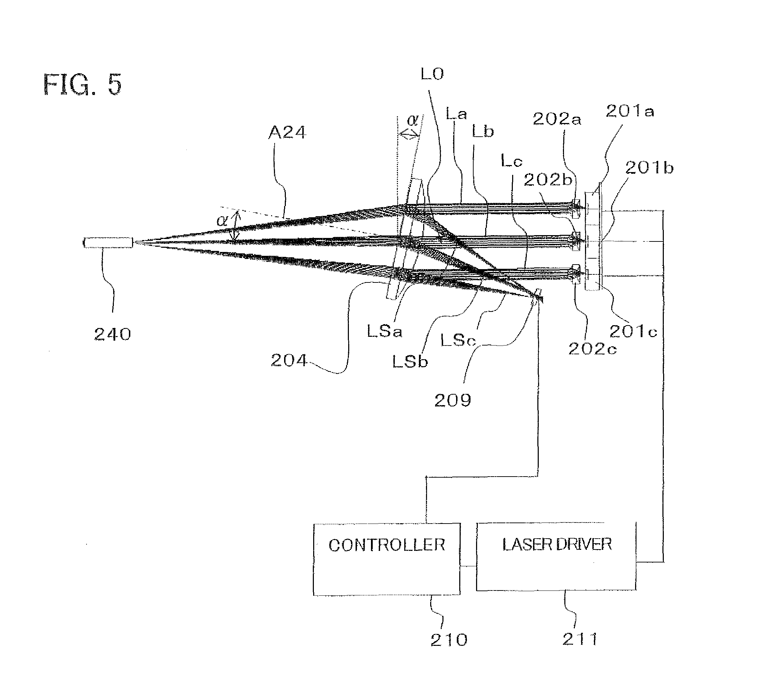

FIG. 5 is a diagram schematically illustrating an example of a structure of a laser light source device according to the first embodiment of the present invention. As shown in FIG. 5, the laser light source device according to the second embodiment has a laser light source 201, a plurality of laser light sources 201a, 201b, 201c; a laser driver (laser driving means) 211 for driving the laser light sources 201a, 201b, 201c; shaping optical elements 202a, 202b, 202c being formed by lenses for approximately parallelizing laser beams La, Lb, Lc emitted from the laser light sources 201a, 201b, 201c, respectively, and the like; and a light-collecting lens 204 which is an optical element for collecting the laser beams La, Lb, Lc and having a spherical surface. Regarding the laser light source 201, the whole of the plurality of laser light sources 201a, 201b, 201c is also referred to as the laser light source 201. The laser light source device according to the first embodiment has an optical sensor 209, in a position where reflected laser beams (sample beams) from the light-collecting lens 204 are collected, for outputting a detection signal corresponding to beam powers of the reflected laser beams; and a controller 210 for controlling driving of the laser light source 201 by the laser driver 211 in accordance with the detection signal from the optical sensor 209. At a position where transmission beams from the light-collecting lens 204 are collected, the laser light source device has an optical fiber 240 for combining and transmitting the laser beams. An incidence end surface of the optical fiber 240 is disposed in a position in consideration of a deviation amount of an optical axis which is determined from the Equations 1 and 2.

Because the laser light source device according to the second embodiment uses approximately parallel light fluxes which are emitted from the plurality of laser light sources 201a, 201b, 201c, all of the reflected beams LSa, LSb, LSc of the laser light fluxes La, Lb, Lc should be received by the optical sensor 209, in order to detect a beam power of the main laser beam LM correctly.

According to the structure of the second embodiment, the reflected laser beams LSa, LSb, LSc which are reflected by the exit surface 24b of the light-collecting lens 204 are collected by a lens power of the light-collecting lens 204, and a spot is formed so that the light fluxes emitted from the laser light sources are superimposed on the optical sensor 209 which is disposed in a collection point where the beams are collected. Thus, approximately all of the reflected light fluxes LSa, LSb, LSc can be received by the optical sensor 209 and the beam power of the main laser beam LM can be correctly sensed.

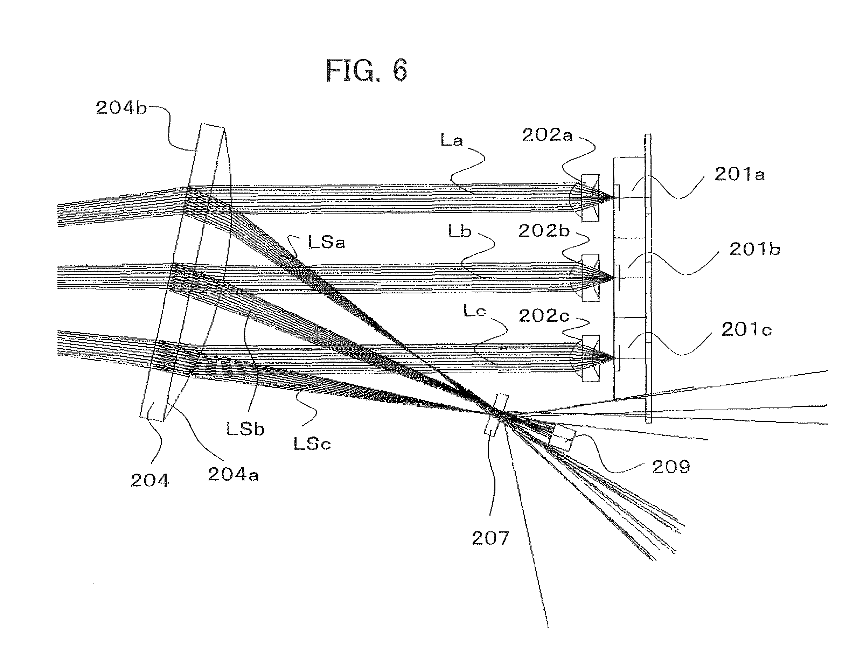

It may be structured, as shown in FIG. 6, so that a diffusion plate 207 is disposed in the position where the reflected beams LSa, LSb, LSc are collected, i.e., the position where the optical sensor 209 is disposed in FIG. 5, and the optical sensor 209 is disposed in front of the diffusion plate 207 along a reflected-light propagating direction (on a downstream side in the reflected-light propagating direction). In usual, a laser beam has an intensity distribution on a section at a right angle to its optical axis and a focused spot has an intensity distribution which reflects it. Focused spots of the laser beams La, Lb, Lc emitted from the plurality of laser light sources 201a, 201b, 201c do not always agree in position and size, due to a difference in a beam characteristic, precision in disposition or the like. The plurality of reflected laser beams LSa, LSb, LSc which have irregularities are scattered during passing through the diffusion plate 207, an intensity distribution is equalized by the scattering, stable reflected laser beams are incident on the optical sensor 209, and thus the beam power of the main laser beam LM can be correctly estimated. That is, because the diffusion plate 207 is disposed in front of a light receiving surface of the optical sensor 209, the intensity distribution or irregularities of the reflected laser beam LS which is incident on the optical sensor 209 is equalized, the reflected laser beam LS which is received by the optical sensor 209 and the main laser beam LM are approximately proportional in intensity, the beam power of the main laser beam LM can be correctly estimated and controlled. Moreover, an equalized intensity distribution area is enlarged, disposition flexibility of the optical sensor 209 is improved, and as a result, a beam intensity distribution at a focused spot is equalized, and an incident light intensity on a receiving unit of the optical sensor 209 can be stabilized.

In the second embodiment, the plurality of laser light sources 201a, 201b, 201c may be either light sources of the same color or light sources of different colors (wavelengths).

Third Embodiment

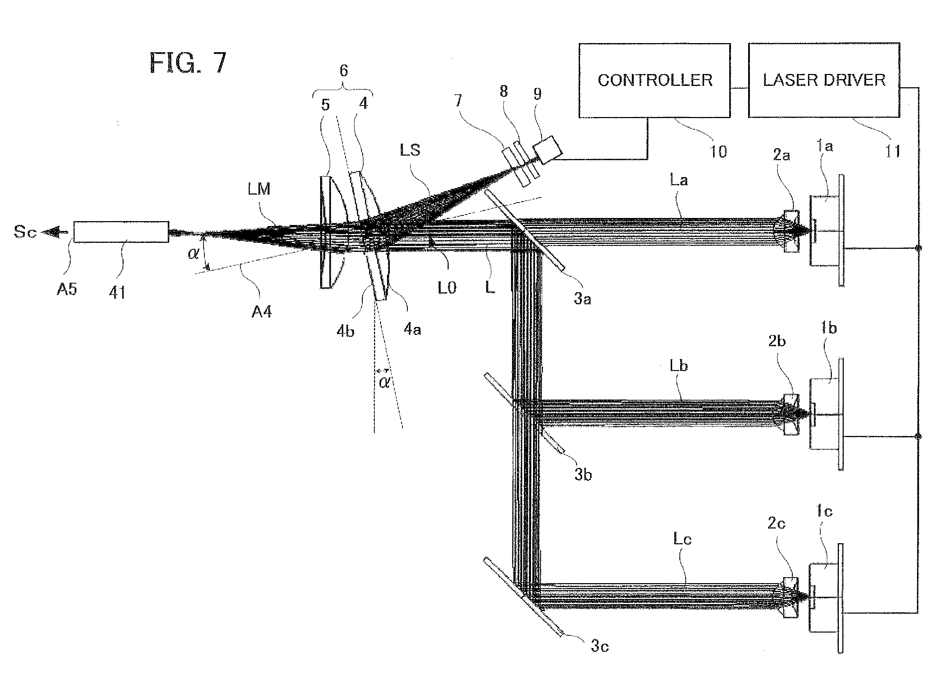

FIG. 7 is a diagram schematically illustrating an example of a structure of a laser light source device according to a third embodiment of the present invention. As shown in FIG. 7, the laser light source device according to the third embodiment has laser light sources (laser modules) 1a, 1b, 1c of three primary colors, for example, red, blue and green; a laser driver (laser driving means) 11 for driving the laser light sources 1a, 1b, 1c; shaping optical elements 2a, 2b, 2c being formed by lenses for approximately parallelizing color laser beams La, Lb, Lc emitted from the laser light sources 1a, 1b, 1c, respectively, and the like; dichroic filters 3a, 3b and a bending mirror 3c for making central rays (also referred to as an 'optical axis') of the laser beams La, Lb, Lc approximately agree with each other and synthesizing them to produce a laser beam L; and a light-collecting lens system 6 including light-collecting lenses 4 and 5 which are optical elements with spherical surfaces for collecting the laser beam L. Here, the dichroic filter 3b is a filter for reflecting the laser beam Lb and transmitting the laser beam Lc. The dichroic filter 3a is a filter for transmitting the laser beam La and reflecting the laser beams Lb, Lc. The laser light source device according to the third embodiment has, in an optical path of a reflected laser beam (sample beam) from the light-collecting lens 4, a diffusion plate 7; a wavelength filter 8; an optical sensor 9 for outputting a detection signal corresponding to a beam power of the reflected laser beam; and a controller 10 for controlling driving of the laser light sources 1a, 1b, 1c by the laser driver 9 in accordance with the detection signal from the optical sensor 9. In a position where a transmission beam from the light-collecting lens 4 is collected, an aperture of an image display apparatus (also referred to as an aperture of the engine, here, an integrator rod) 41 is disposed.

In the third embodiment, the light-collecting lens system 6 includes the two light-collecting lenses (spherical lenses) 4 and 5. The light-collecting lens 4 (the light-collecting lens which is disposed on an upstream side in a laser-light propagating direction) on which the laser beam L is incident is disposed in an eccentric-rotated state so that an optical axis A4 of the light-collecting lens 4 has a tilt (angle $\alpha$) with respect to a central ray (also referred to as 'optical axis') L0 of the laser beam L which is incident on the light-collecting lens 4. A rotation axis of the eccentric-rotation has a rotation axis (a rotation axis extending in a direction perpendicular to a sheet on which FIG. 7 is illustrated) on a surface at a right angle to the central ray L0 of the laser beam L which is incident on the light-collecting lens 4. The light-collecting lenses 4 and 5 have a low reflection coating on their surfaces, except on an exit surface 4b of the light-collecting lens 4, to reduce loss due to Fresnel reflection. Because the light-collecting lens 4 is eccentric-rotated at the angle $\alpha$, a reflected beam at the exit surface 4b of the light-collecting lens 4 has an optical path which returns inside the light-collecting lens 4 and then exits from an incidence surface 4a to the air, and the beam is a reflected laser beam (sample beam) LS which is detected by the optical sensor 9, apart from a main laser beam LM. The reflected laser beam LS passes through the diffusion plate 7 and the wavelength filter 8, and then is incident on the optical sensor 9. Because a beam power of the reflected laser beam LS which is detected by the optical sensor 9 has a constant relationship (an approximately proportional relationship, for example) to a beam power of the main laser beam LM, it is equal to that the optical sensor 9 detects the beam power of the main laser beam LM which exits from the laser light source device.

On the other hand, the main laser beam LM which is a transmission beam from the light-collecting lens 5 exits from the laser light source device and is connected with the aperture of the engine of the image display apparatus (the integrator rod in this embodiment), and a projector SC for spatial modulating the laser beam onto a screen (which is not shown in the drawing and includes a spatial modulating element, an illuminator for illuminating the spatial modulating element with the main laser beam LM, an optical system for projecting a spatial-modulated beam onto the screen, and the like, for example) is provided.

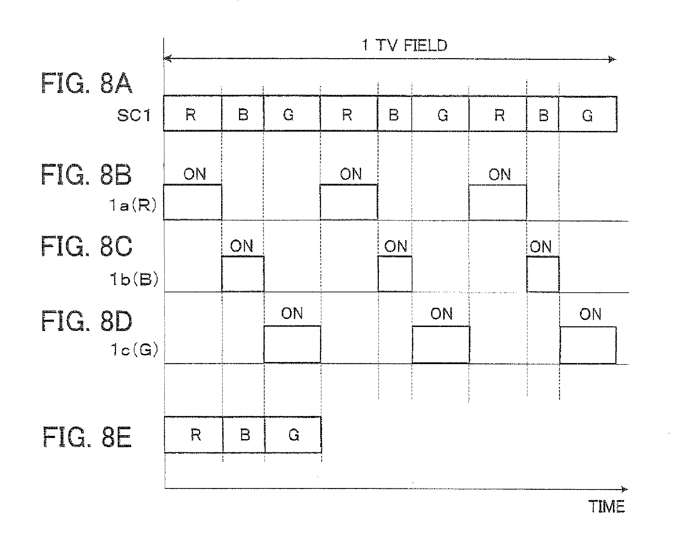

FIGs. 8A to 8E are diagrams for explaining drive timings of a field sequential spatial modulating element and the lasers when the laser light source device according to the third embodiment is applied to the image display apparatus. As the third embodiment, the image display apparatus which uses the laser light source device using synthesized three primary-color laser beams has a structure that the spatial modulating element for performing gradation display according to a field sequential method, for example, is disposed. The field sequential method uses a principle that, as shown in FIG. 8A, 1 TV field period is divided into the number of colors of the light sources (here, the three colors of R, G, and B), the colors are successively outputted, and the colors are mixed in the human eye by an integral function of the human eye to be recognized as a full-color image. On the same principle, gradation display is performed for each of the colors by dividing a time corresponding to one of the colors into 10 bits, i.e., 1024 divisions and changing light use frequency in response to light intensity of the color. As shown in FIGs. 8B, 8C and 8D, in synchronization with an operation of the spatial modulating element SC1 (not shown in the drawings), the laser light sources 1a, 1b, 1c are pulse-driven so as to oscillate only during corresponding operation times of the spatial modulating element for the colors of the light sources, respectively. As the spatial modulating element, a DMD (digital micromirror device) or a liquid crystal light bulb is available, for example.

As shown in FIG. 8E, the optical sensor 9 detects optical outputs which are received in synchronization with ON-timings of the color laser light sources 1a, 1b, 1c, and outputs electric signals which correspond to them to the controller 10, thereby the color laser light sources can be individually controlled. The controller 10 estimates the beam power of the main laser beam LM from a relation between an output of the optical sensor 9 which is determined in advance and the beam power of the main laser beam LM, and controls input signals to the three primary-color lasers so as to obtain a predetermined beam power, to output a laser beam which has a stable beam power. The optical sensor 9 may detect an optical output of the reflected laser beam LS in synchronization with one or more ON timings in 1 TV field, instead of in synchronization with all ON timings of the color laser light sources 1a, 1b, 1c.

In the third embodiment, a light-collecting angle of an emission beam is approximately 25 degrees. In this case, the structure of the light-collecting lens system 6 depends on a beam spot diameter required for a collection beam. However, in general, the light-collecting lens system 6 is usually formed by one or two spherical lenses, or by a single aspheric lens, for example. The light-collecting lens system 6 has the structure of the pair of spherical lenses as shown in FIG. 7, for example. The pair of spherical lenses enables to reduce a lens power of each of the light-collecting lenses, thereby a refractive index of lens material can be reduced. As a result, as shown in FIG. 2, Fresnel reflectance (represented by a vertical axis) is reduced and light loss in the main laser beam can be reduced. On the other hand, when the same performance is desired by the light-collecting lens which is formed by a single spherical lens, it is required to use lens material of a high refractive index and it causes an increase in Fresnel reflection loss. In usual, because the optical sensor 9 requires a slight optical amount to detect the reflected laser beam LS (weak light intensity is sufficient), it is not required to increase intensity of light which is incident on the optical sensor 9 by increasing Fresnel reflectance.

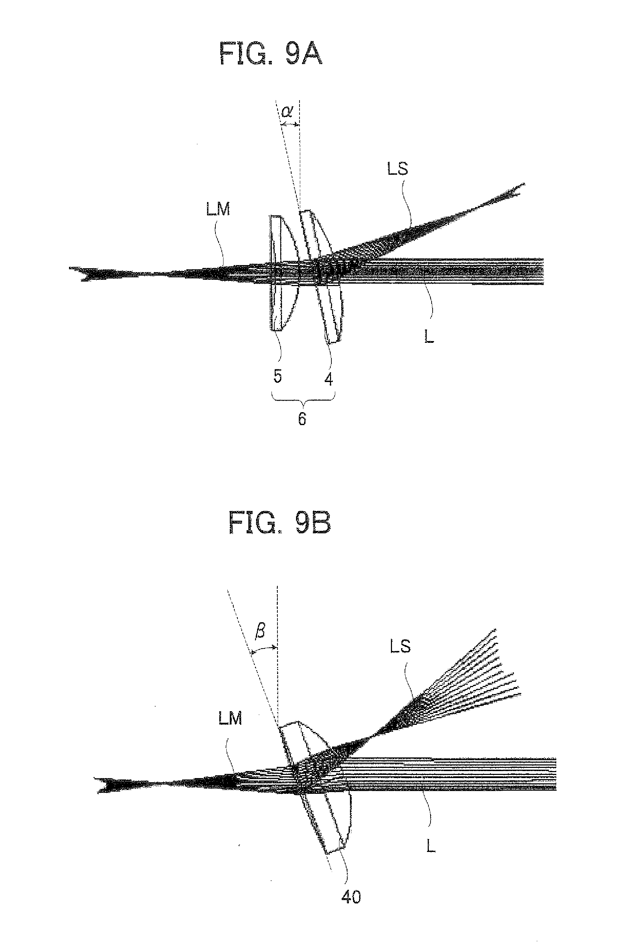

FIG. 9A is a diagram illustrating an eccentric-rotated state of the light-collecting lens 4 in the light-collecting lens system 6; and FIG. 9B is a diagram illustrating an eccentric-rotated state when the light-collecting lens system 6 is formed by a single light-collecting lens 40. As shown in FIG. 9B, when the light-collecting lens system 6 which is formed by the single light-collecting lens 40 has a large lens power, a focal length of the reflected laser beam LS is short. For this reason, as shown in FIG. 9B, an angle $\beta$ of the light-collecting lens 40 which is required to separate optical paths of the reflected laser beam LS and the main laser beam LM is required to be larger than that in FIG. 9A (the angle $\alpha$), and Fresnel reflectance increases and a focused spot deteriorates due to astigmatism. Thus, light loss is less and high performance is easily obtained in the case that the light-collecting lens system 6 has the two light-collecting lenses 4 and 5, in comparison with the case of the single light-collecting lens 40. On the other hand, if the light-collecting lens system 6 is formed by a plurality of lenses, a cost increases and interface loss increasingly arises even if the low reflection coating is applied. For this reason, as the number of the lenses forming the light-collecting lens system 6, an optimum number can be selected in accordance with a specification of the emission beam and the like, and the number may be other than two of the example illustrated in the drawing.

Next, a function of the diffusion plate 7 which is disposed near a focused spot of the reflected laser beam LS is the same as the function which is explained in the second embodiment. In the case that the laser light sources of different wavelengths are used, irregularities in a focused spot of the reflected laser beam further increase, in comparison with the case that a plurality of laser light sources of a same color are used, and thus an effect of using the diffusion plate is enhanced.

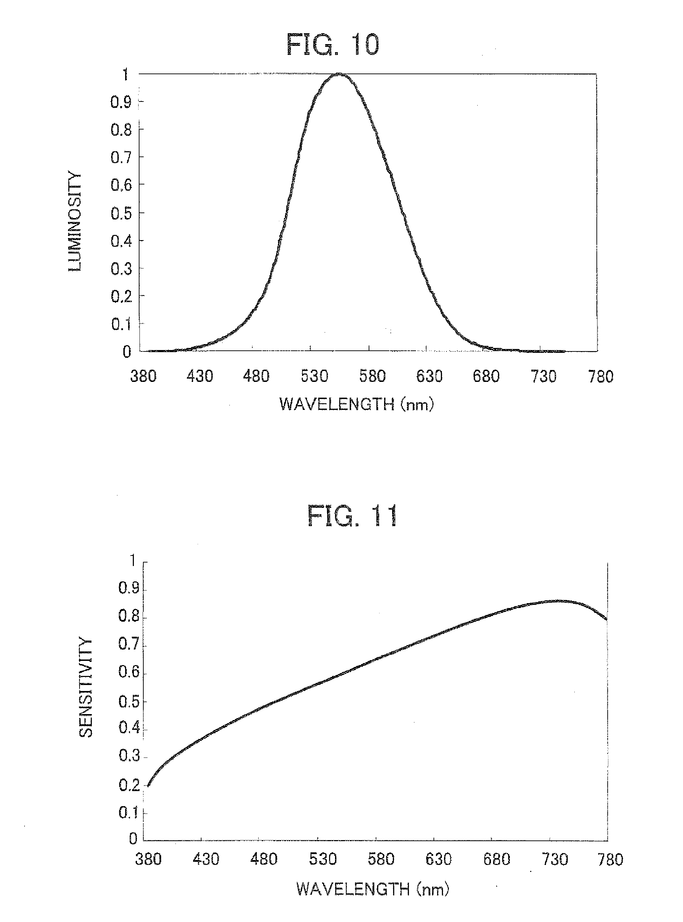

FIG. 10 is a graph of a luminosity curve; and FIG. 11 is a graph of an example of a wavelength sensitivity of the optical sensor. In the first embodiment, the wavelength filter 8 is disposed between the diffusion plate 7 and the light-collecting lens 4. An oscillation wavelength of a laser beam may change due to temperature or a drive current. As shown in FIG. 10, when the oscillation wavelength varies, a color variation is recognized in a monochrome color, and the human eye sensitivity differently senses and a color tone is differently seen, even if colors of a same beam power are mixed. For this reason, it is desirable that the wavelength sensitivity of the optical sensor 9 have a similar characteristic to the visual sensitivity of the human eye. On the other hand, a degree of light absorption of material for a light receiving element (such as silicon) of the optical sensor 9 varies with the wavelength as an example shown in FIG. 11, and an output from the optical sensor 9 varies with the wavelength. For this reason, a characteristic of the wavelength filter 8 is determined so that a wavelength sensitivity characteristic which is a combination of the sensitivity of the optical sensor 9 and the wavelength filter 8 approximately agrees with the visual sensitivity. If the laser light source device which has this structure is used as a light source for illuminating the spatial modulating element in the projection-type image display apparatus with a laser beam, light intensity of color laser beams used for displaying an image can be appropriately controlled, thereby brightness and a color tone of the display image can be stabilized and color reproductivity can be improved.

That is, the wavelength filter 8 is disposed in front of a light receiving surface of the optical sensor 9, thereby the beam power of the main laser beam LM can be adjusted to correct a variation in the laser oscillation wavelength due to temperature or aging deterioration.

The wavelength filter 8 and the diffusion plate 7 may be inversely disposed. It is not limited that the characteristic of the wavelength filter 8 is to correct the visual sensitivity and the wavelength sensitivity of the optical sensor, but the characteristic is sufficient to compensate an output from the light source which is required for an apparatus, a characteristic which changes due to environmental condition or change because of aging.

Although the case that the optical sensor 9 is single is explained in the above description, an optical sensor which has a plurality of light receiving elements of a high light receiving sensitivity to oscillation wavelengths of the laser light sources used for the laser light source device according to the third embodiment may be adopted.

As described above, the laser light source device according to the third embodiment detects the reflected laser beam LS from the light-collecting lens 4 which is disposed in a position near a laser light exit position, thereby a beam power of an actual exit laser beam from the laser light source device can be correctly measured.

Because it is structured that the light-collecting lens 4 in the laser light source device is eccentric-rotated in a direction that a rotation axis is included on a perpendicular surface to its optical axis to obtain the reflected laser beam LS which travels to the optical sensor 9, the reflected laser beam LS for sensing can be separated without adding another element in the light-collecting lens system 6 and the laser light source device at low cost and with less light loss can be obtained.

According to the structure of the third embodiment, a beam power of a laser beam can be kept stable without increasing components, thereby brightness and a color tone of a display image can be kept stable.

## EXPLANATION OF REFERENCE NUMERALS

1a, 1b, 1c, 21 laser light source; 2a, 2b, 2c, 22, 202a, 202b, 202c shaping optical element; 3a, 3b dichroic filter; 3c bending mirror; 4, 5, 24, 204 light-collecting lens; 4a incidence surface of light-collecting lens 4; 204a incidence surface of light-collecting lens 204; 4b exit surface of light-collecting lens 4 (Fresnel reflection surface); 204b exit surface of light-collecting lens 204 (Fresnel reflection surface); 6 light-collecting lens system; 7, 207 diffusion plate; 8 wavelength filter; 9, 29, 209 optical sensor; 10, 30 controller; 11, 31 laser driver; L, La, Lb, Lc laser beam; LM main laser beam (main beam); LS reflected laser beam (sample beam); $\alpha$, $\beta$ angle of eccentric-rotation; $\rho$ angle of refraction; A4 optical axis of light-collecting lens 4; A5 optical axis of light-collecting lens 5; A24 optical axis of light-collecting lens 24; L0 central ray of laser beam L; 140, 240 optical fiber; 41 aperture of the engine.

## Claims

1.  A laser light source device comprising:

    a laser light source for emitting a laser beam;
    a laser driving means for driving the laser light source;
    a light collector for collecting the laser beam and including an optical element which reflects a part of the laser beam;
    an optical sensor for receiving a reflected laser beam which has been reflected by the optical element and outputting a detection signal corresponding to intensity of the reflected laser beam; and
    a controlling means for controlling driving of the laser light source by the laser driving means in accordance with the detection signal;
    wherein the optical element is disposed in an eccentric-rotated state so that an optical axis of the optical element has a tilt with respect to a central ray of the laser beam being incident on the optical element.

2.  The laser light source device according to claim 1, wherein the optical element for reflecting the part of the laser beam is a light-collecting lens.

3.  The laser light source device according to claim 2, wherein the light collector includes another light-collecting lens having an optical axis which is parallel to the central ray of the laser beam being incident on the optical element.

4.  The laser light source device according to any one of claims 1 to 3, wherein a surface in the optical element, wherein the surface reflects the part of the laser beam, is a surface on an incidence side or on an exit side of the laser beam.

5.  The laser light source device according to any one of claims 1 to 4, wherein a surface in the optical element, wherein the surface reflects the part of the laser beam, is an uncoated surface.

6. The laser light source device according to any one of claims 1 to 5, wherein a polarization direction of the laser beam is parallel to a reflection surface in the optical element.

7. The laser light source device according to any one of claims 1 to 6, further comprising a diffusion plate disposed in an optical path of the reflected laser beam;
wherein the reflected laser beam received by the optical sensor is the reflected laser beam which has passed through the diffusion plate.

8. The laser light source device according to any one of claims 1 to 7 further comprising a wavelength filter being disposed in the optical path of the reflected laser beam, wherein
the reflected laser beam being received by the optical sensor is a reflected laser beam passing through the wavelength filter.

9. An image display apparatus comprising:

the laser light source device according to any one of claims 1 to 8; and
a means for spatial modulating a laser beam exiting from the laser light source device and projecting it onto a screen.

10. The image display apparatus according to claim 9,
wherein a plurality of the laser light source devices are provided, the plurality of laser light source devices emit primary color laser beams, respectively;
the apparatus further comprising a synthesizing means for synthesizing the plurality of laser beams from the plurality of laser light source devices,
the laser beams to be spatial modulated are laser beams which have been synthesized by the synthesizing means.

# FIG. 1

# FIG. 2

FIG. 3

FIG. 4B

FIG. 4A

EP 2 405 541 A1

FIG. 5

CONTROLLER

LASER DRIVER

210

211

FIG. 6

FIG. 7

EP 2 405 541 A1

FIG. 8A

SC1

| R | B | G | R | B | G | R | B | G |

FIG. 8B

1a(R)

ON ON ON

FIG. 8C

1b(B)

ON ON ON

FIG. 8D

1c(G)

ON ON ON

FIG. 8E

| R | B | G |

1 TV FIELD

TIME

# FIG. 9A

# FIG. 9B

## FIG. 10

## FIG. 11

<table>
<tr><td colspan="2" align="center"><strong>INTERNATIONAL SEARCH REPORT</strong></td><td>International application No.<br>PCT/JP2010/001411</td></tr>
</table>

**A. CLASSIFICATION OF SUBJECT MATTER**
*H01S5/062*(2006.01)i

According to International Patent Classification (IPC) or to both national classification and IPC

**B. FIELDS SEARCHED**

Minimum documentation searched (classification system followed by classification symbols)
H01S5/00-5/50

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2007-27523 A  (Fuji Xerox Co., Ltd.),<br>01 February 2007 (01.02.2007),<br>paragraphs [0001] to [0042]; fig. 1 to 18<br>& US 2007/0019960 A1 | 1-10 |
| Y | JP 2002-374026 A  (Ricoh Optical Industries Co., Ltd.),<br>26 December 2002 (26.12.2002),<br>paragraphs [0001] to [0069]; fig. 1 to 4<br>(Family: none) | 1-10 |
| Y | JP 2008-270506 A  (Nippon Telegraph And Telephone Corp.),<br>06 November 2008 (06.11.2008),<br>paragraphs [0001] to [0032]; fig. 1, 2<br>(Family: none) | 3-10 |

| ☒ Further documents are listed in the continuation of Box C. | ☐ See patent family annex. |
|---|---|

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>24 March, 2010 (24.03.10) | Date of mailing of the international search report<br>06 April, 2010 (06.04.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/001411 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 5-196845 A  (Ishikawajima-Harima Heavy Industries Co., Ltd.),<br>06 August 1993 (06.08.1993),<br>paragraphs [0011] to [0038]; fig. 1 to 5<br>(Family: none) | 6-10 |
| Y | JP 5-145163 A  (Fuji Photo Film Co., Ltd.),<br>11 June 1993 (11.06.1993),<br>paragraphs [0015] to [0018]; fig. 3<br>(Family: none) | 7-10 |
| Y | JP 2004-207434 A  (Mitsubishi Electric Corp.),<br>22 July 2004 (22.07.2004),<br>paragraphs [0008] to [0022]; fig. 1 to 4<br>(Family: none) | 8-10 |
| Y | JP 2008-244440 A  (Matsushita Electric Industrial Co., Ltd.),<br>09 October 2008 (09.10.2008),<br>paragraphs [0097] to [0101]; fig. 15<br>& US 2008/0192787 A1 | 9,10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5133798 A

- JP 2003270579 A